# EUROPÄISCHE PATENTSCHRIFT

(11) **EP 3 074 986 B1**
(45) Veröffentlichungstag und Bekanntmachung des Hinweises auf die Patenterteilung: **08.11.2023**
(21) Anmeldenummer: 14802889.7
(22) Anmeldetag: 25.11.2014
(51) Int. Cl.: H01C 1/06, H01G 4/30, H01C 7/18, H01G 2/22, H01G 4/224, H01L 23/552

(54) **ELEKTRONISCHES BAUELEMENT UND VERWENDUNG DESSELBEN**
ELECTRONIC COMPONENT AND USE THEREOF
COMPOSANT ÉLECTRONIQUE ET SON UTILISATION

(30) Priorität: 29.11.2013 DE 102013113264; 16.01.2014 DE 102014100469
(43) Veröffentlichungstag der Anmeldung: 05.10.2016
(73) Patentinhaber: TDK Electronics AG, 81671 München (DE)
(72) Erfinder: DERNOVSEK, Oliver, A-8501 Lieboch (AT); FEICHTINGER, Thomas, A-8010 Graz (AT)
(74) Vertreter: Epping - Hermann - Fischer
(86) Internationale Anmeldenummer: PCT/EP2014/075562
(87) Internationale Veröffentlichungsnummer: WO 2015/078873

(56) Entgegenhaltungen:
- EP-A1- 1 858 033
- WO-A1-2012/081815
- WO-A2-2009/075530
- US-A1- 2007 075 323

## Beschreibung

Die vorliegende Erfindung betrifft ein elektronisches Bauelement, ein System mit einem elektronischen Bauelement und die Verwendung eines elektronischen Bauelements.

WO 2012/081815 A1 zeigt einen Varistorkörper, auf dessen Oberseite eine Leuchtdiode montiert ist, wobei die Oberseite des Varistorkörpers eine Verstärkungsschicht und eine reflektierende Schicht aufweist. US 2007/075323 A1 zeigt eine Anordnung, bei der ein lichtemittierendes Element auf einem Vielschichtvaristorchip angeordnet ist, der eine reflektierende Schicht aufweist.

Eine zu lösende Aufgabe ist es, ein verbessertes elektronisches Bauelement anzugeben.

Diese Aufgabe wird durch das elektronische Bauelement mit den Merkmalen des unabhängigen Patentanspruchs gelöst. Vorteilhafte Ausgestaltungen und Weiterbildungen sind Gegenstand der abhängigen Patentansprüche.

Ein vorgeschlagenes elektronisches Bauelement umfasst einen Funktionskörper, der mit einer Reflexionsstruktur versehen ist, wobei die Reflexionsstruktur angeordnet und ausgebildet ist, von außen auf das elektronische Bauelement treffende Strahlung von dem Funktionskörper weg zu reflektieren. Die genannte Reflexion bezieht sich vorzugsweise auf eine Reflexion von Strahlung, insbesondere elektromagnetischer Strahlung. Der Funktionskörper des elektronischen Bauelements ist weiterhin vorzugsweise für die Funktion des elektronischen Bauelements und dessen elektronische Eigenschaften wesentlich. Demgemäß handelt es sich bei dem Funktionskörper vorzugsweise nicht um ein Gehäuse oder um eine für die Funktion des elektronischen Bauelements unwesentliche Komponente.

Die Reflexionsstruktur weist vorzugsweise nichtmetallische Eigenschaften auf. Die Reflexionsstruktur kann eine oder mehrere Schichten aufweisen. Weiterhin unterscheidet sich die Reflexionsstruktur vorzugsweise von Lackschichten oder Lacken und/oder Lösungsmittel enthaltenden Beschichtungen durch eine wesentlich höhere Temperaturstabilität oder thermische Beständigkeit in Bezug auf die mechanischen, elektronischen und optischen Eigenschaften. Beispielsweise kann eine Schmelztemperatur der Reflexionsstruktur oberhalb von 1500 °C und damit weit oberhalb von Temperaturen liegen, bei denen Lackbeschichtungen zerfallen und/oder bezüglich der oben genannten Eigenschaften degradieren.

Durch das elektronische Bauelement, insbesondere durch die Reflexionsstruktur, kann mit Vorteil die Reflexion von elektromagnetischer Strahlung, welche von außen auf das elektronische Bauelement trifft, erhöht werden. Auf diese Weise kann beispielsweise die Lichtausbeute, die abgestrahlte Lichtleistung und/oder die optische Effizienz eines Bauteils oder Bauelements erhöht werden, welches mit dem elektronischen Bauelement eine funktionale Einheit bildet, sofern das elektronische Bauelement optisch mit dem genannten Bauteil wechselwirken kann und/oder von diesem emittierte oder transmittierte Strahlung reflektieren kann.

Als weiterer Vorteil kann durch die Reflexionsstruktur des elektronischen Bauelements einer Erwärmung des elektronischen Bauelements, beispielsweise durch von dem genannten Bauteil emittierte Strahlung aufgrund der erhöhten Rückstrahlung oder Reflexion von Strahlung an der Reflexionsstruktur vorgebeugt werden. Dadurch kann beispielsweise in dem Fall, dass das elektronische Bauelement als NTC-Bauelement ausgebildet ist, die Beeinträchtigung einer Temperaturmessung verhindert werden.

Das elektronische Bauelement ist ein strahlungspassives Bauelement. Der Ausdruck "strahlungspassiv" soll vorliegend bedeuten, dass das elektronische Bauelement kein Bauelement ist, das zur Erzeugung oder zum Empfang von elektromagnetischer Strahlung ausgebildet oder eingerichtet ist. Das Bauelement emittiert oder erzeugt aktiv vorzugsweise keine elektromagnetische Strahlung beispielsweise durch Ladungsträgerrekombination. Vorzugsweise ist das elektronische Bauelement in diesem Zusammenhang kein optoelektronisches Bauelement. Das Bauelement ist mit Vorzug zumindest strahlungspassiv für Strahlung des sichtbaren, ultravioletten und/oder infraroten Spektralbereichs. Insbesondere ist das Bauelement vorzugsweise keine Lumineszenzdiode.

In einer bevorzugten Ausgestaltung ist das Material einer äußeren Oberfläche der Reflexionsstruktur elektrisch isolierend. Durch diese Ausgestaltung kann mit Vorteil ein signifikanter Fluss von elektrischem Strom durch die Reflexionsstruktur verhindert werden, was insbesondere, wenn die Reflexionsstruktur an einer äußeren Oberfläche mit weiteren elektrisch leitenden Materialien, beispielsweise Außenelektroden, in Kontakt steht, zweckmäßig ist, da ein unerwünschter elektrischer Kurzschluss zwischen den genannten Komponenten verhindert werden kann.

In einer bevorzugten Ausgestaltung umfasst der Funktionskörper eine Keramik als funktionales Element oder besteht aus einer Keramik. Gemäß dieser Ausgestaltung kann das elektronische Bauelement vorzugsweise als Varistor, Kondensator, PTC-Bauelement, NTC-Bauelement oder als piezoelektrisches Bauelement ausgeführt werden.

In einer bevorzugten Ausgestaltung ist das elektronische Bauelement ein Varistor, ein Kondensator, ein PTC-Bauelement, ein NTC-Bauelement, ein Ferrite enthaltendes Bauelement oder ein piezoelektrisches Bauelement.

In einer Ausgestaltung umfasst der Funktionskörper ein nicht-keramisches Halbleitermaterial als funktionales Element oder besteht aus einem Halbleitermaterial. Gemäß dieser Ausgestaltung kann das elektronische Bauelement vorzugsweise als Halbleiterbauelement, beispielsweise als Diode ausgeführt werden.

In einer bevorzugten Ausgestaltung weist die Reflexionsstruktur eine Schichtdicke zwischen 1 µm und 10 µm, bevorzugt zwischen 2 µm und 3 µm, auf.

In einer bevorzugten Ausgestaltung weist die Reflexionsstruktur für von außen auf das elektronische Bauelement treffende Strahlung eines vorgegebenen Spektralbereichs einen größeren Reflexionsfaktor und/oder Reflexionsgrad auf als der Funktionskörper. Dies ermöglicht zweckmäßigerweise eine erhöhte Reflexion von Strahlung, insbesondere elektromagnetischer Strahlung im Gegensatz zu dem Funktionskörper.

Der Begriff "Reflexionsfaktor" oder "Reflexionskoeffizient" kann das Amplitudenverhältnis zwischen einer reflektierten und einfallenden Welle beim Übergang in ein anderes Ausbreitungsmedium, also beispielsweise von der äußeren Umgebung in die Reflexionsstruktur, beschreiben. Die Amplitude bezieht sich dabei vorzugsweise auf die elektrische Feldstärke der entsprechenden elektromagnetischen Welle.

Der Begriff "Reflexionsgrad" oder "Reflektivität" kann das Verhältnis zwischen reflektierter und einfallender Intensität einer elektromagnetischen Welle als Energiegröße beschreiben.

In einer bevorzugten Ausgestaltung umfasst der vorgegebene Spektralbereich den sichtbaren Spektralbereich oder besteht aus diesen. Der sichtbare Spektralbereich kann den vorgegebenen Spektralbereich definieren.

In einer bevorzugten Ausgestaltung umfasst der vorgegebene Spektralbereich den infraroten Spektralbereich, den sichtbaren Spektralbereich und den ultravioletten Spektralbereich. Der infrarote Spektralbereich wird beispielsweise durch den Wellenlängenbereich von elektromagnetischer Strahlung zwischen 1 mm und 780 nm definiert. Der sichtbare Spektralbereich wird beispielsweise durch den Wellenlängenbereich elektromagnetischer Strahlung (Lichtspektrum) zwischen 380 nm und 780 nm definiert. Der ultraviolette Spektralbereich wird hingegen beispielsweise durch den Wellenlängenbereich von elektromagnetischer Strahlung zwischen 100 nm und 380 nm definiert.

In einer bevorzugten Ausgestaltung ist die Reflexionsstruktur derart ausgebildet, dass sie für von außen auf das elektronische Bauelement treffende Strahlung des vorgegebenen Spektralbereichs einen Reflexionsfaktor und/oder Reflexionsgrad von R > 0,9 aufweist. Durch diese Ausgestaltung kann vorteilhafterweise von außen auf das elektronische Bauelement treffende Strahlung größtenteils von dem Funktionskörper und dem elektronischen Bauelement weg reflektiert werden, so dass gleichzeitig eine Absorption der genannten Strahlung durch den Funktionskörper weitgehend verhindert wird. Damit kann, wie oben beschrieben, beispielsweise die Lichtleistung eines weiteren Bauteils, welches optisch mit dem elektronischen Bauelement wechselwirkt, erhöht werden. Mit anderen Worten kann durch die Reflexionsstruktur vorteilhafterweise verhindert werden, dass ein maßgeblicher Anteil der von außen auf das elektronische Bauelement treffenden Strahlung von dem Funktionskörper absorbiert wird. Dies bietet insbesondere Vorteile gegenüber Keramikkörpern mit dunklen Oberflächen.

In einer bevorzugten Ausgestaltung weist das elektronische Bauelement elektrisch voneinander isolierte Innenelektroden auf, die innerhalb des Funktionskörpers angeordnet sind. Vorzugsweise sind die genannten Innenelektroden weitgehend in dem Funktionskörper angeordnet, beziehungsweise ragen in diesen hinein. Dabei können jedoch schmale oder kurze Bereiche der Innenelektroden, welche für eine elektrische Kontaktierung der Innenelektroden notwendig sind, aus dem Funktionskörper herausstehen oder nicht von diesem umschlossen sein.

In einer bevorzugten Ausgestaltung weist das elektronische Bauelement Außenelektroden auf, die außerhalb des Funktionskörpers angeordnet sind. Durch diese Ausgestaltung können beispielsweise die Innenelektroden elektrisch kontaktiert und für einen elektrischen Anschluss des elektronischen Bauelements zugänglich gemacht werden.

In einer bevorzugten Ausgestaltung sind zwei Außenelektroden elektrisch voneinander isoliert und mit verschiedenen elektrisch voneinander isolierten Innenelektroden elektrisch leitfähig verbunden. Diese Ausgestaltung ist für eine Vielzahl von elektronischen Bauelementen, insbesondere Vielschichtbauelementen, mit zwei Haupt-Außenelektroden und einer Vielzahl von Innenelektroden besonders zweckmäßig.

In einer bevorzugten Ausgestaltung bedecken die Außenelektroden die Reflexionsstruktur, beispielsweise an Stirnseiten des Funktionskörpers, teilweise. Die Stirnseiten bilden dabei vorzugsweise im Vergleich zu weiteren Hauptoberflächen des elektronischen Bauelements kleine oder kleinere Oberflächen oder weisen diese auf.

In einer bevorzugten Ausgestaltung ist die Reflexionsstruktur zumindest teilweise zwischen den Außenelektroden und dem Funktionskörper angeordnet. Die Reflexionsstruktur ist dabei weiterhin in Elektrodenbereichen, in denen die Außenelektroden mit den Innenelektroden elektrisch leitfähig verbunden sind, unterbrochen. Gemäß dieser Ausgestaltung kann beispielsweise der Funktionskörper vor dem Versehen desselben mit den genannten Außenelektroden zunächst mit der Reflexionsstruktur überzogen oder versehen werden. Diese Ausgestaltung ermöglicht weiterhin zweckmäßigerweise die elektrisch leitfähige Verbindung zwischen den Außenelektroden und den Innenelektroden in den Elektrodenbereichen durch die Reflexionsstruktur hindurch.

In einer bevorzugten Ausgestaltung umfasst die Reflexionsstruktur ein Matrixmaterial.

In einer bevorzugten Ausgestaltung umfasst die Reflexionsstruktur strahlungsreflektierende Partikel, welche in dem Matrixmaterial der Reflexionsstruktur angeordnet sind. Durch diese Ausgestaltung kann mit Vorteil die oben beschriebene Strahlung von den genannten Partikeln der Reflexionsstruktur gestreut und/oder reflektiert werden.

In einer bevorzugten Ausgestaltung bestehen die strahlungsreflektierenden Partikel aus zumindest einem der Materialien Titanoxid, Aluminiumoxid, Magnesiumoxid, Magnesiumsilikat, Bariumsulfat, Zinkoxid und Zirkoniumoxid oder enthalten zumindest eines der genannten Materialien.

Der Ausdruck "reflektierend" kann in diesem Zusammenhang bedeuten, dass die reflektierenden Partikel für auf diese treffende elektromagnetische Strahlung eine Reflektivität und/oder einen Reflexionsgrad oder einen Reflexionsfaktor von vorzugsweise 0,9 (R > 0,9) oder mehr aufweisen.

Das elektronische Bauelement umfasst eine Schutzschicht, die auf der Reflexionsstruktur angeordnet ist. Die Schutzschicht ist vorzugsweise ausgebildet, das elektronische Bauelement mechanisch vor äußeren Einflüssen jeglicher Art zu schützen.

Alternativ zu dieser Ausgestaltung kann die Reflexionsstruktur von sich aus als Schutzschicht oder mit - wie oben beschriebenen - schützenden Eigenschaften ausgestaltet sein.

In einer bevorzugten Ausgestaltung besteht die Schutzschicht aus einem Glas oder einem Harz, beispielsweise einem Epoxid, oder umfasst eines dieser Materialien.

In einer alternativen Ausgestaltung ist die Schutzschicht durch chemische Gasphasenabscheidung, beispielsweise plasmaunterstützte chemische Gasphasenabscheidung hergestellt. Gemäß dieser Ausgestaltung kann die Reflexionsstruktur beispielsweise mit einer geringeren und/oder genau definierten Schichtdicke oder Abmessung bereitgestellt werden.

In einer Ausgestaltung weist die Schutzschicht eine Schichtdicke zwischen 10 nm und 1 µm aufweist. Gemäß dieser Ausgestaltung ist die Schutzschicht vorzugsweise mittels chemischer Gasphasenabscheidung abgeschieden oder aufgebracht worden.

Das elektronische Bauelement umfasst eine Barriereschicht, die zwischen dem Funktionskörper und der Reflexionsstruktur angeordnet ist. Die Barriereschicht ist vorzugsweise als "Materialbarriere" zwischen dem Funktionskörper und der Reflexionsstruktur vorgesehen, um beispielsweise eine Materialdiffusion von dem Funktionskörper in die Reflexionsschicht als auch von der Reflexionsschicht in den Funktionskörper zu verhindern oder einzuschränken. Insbesondere Dotierstoffe des Funktionskörpers könnten ohne die Barriereschicht, beispielsweise während des Herstellungsprozesses des elektronischen Bauteils, in die Reflexionsschicht diffundieren und deren optische Eigenschaften beeinträchtigen. Umgekehrt könnten ebenfalls Pigmente oder andere Stoffe oder Bestandteile der Reflexionsschicht in den Funktionskörper diffundieren und dessen elektrische oder dielektrische Eigenschaften beeinträchtigen.

In einer bevorzugten Ausgestaltung ist das elektronische Bauelement oberflächenmontierbar und/oder in Wende- oder "flip-chip"-Montage ausgebildet.

In einer bevorzugten Ausgestaltung ist die Reflexionsstruktur durch Aufstäuben, Aufsprühen oder Siebdruck herstellbar oder hergestellt.

In einer Ausgestaltung umschließt die Reflexionsstruktur den Funktionskörper entlang eines Umfangs des Funktionskörpers nur teilweise, beispielsweise ausschließlich an einzelnen Seiten und/oder Seitenflächen des Funktionskörpers. Durch diese Ausgestaltung können die reflektierenden oder optischen Eigenschaften der Reflexionsstruktur mit Vorteil selektiv nur für einzelne Seiten oder Vorzugsrichtungen des Funktionskörpers ausgenutzt werden.

In einer Ausgestaltung umschließt die Reflexionsstruktur den Funktionskörper entlang eines Umfangs des Funktionskörpers vollständig. Die Reflexionsstruktur kann den Funktionskörper beispielsweise an allen Seitenflächen umschließen oder umhüllen, an denen der Funktionskörper nicht mit den Außenelektroden verbunden ist. Auf diese Weise können insbesondere die reflektierenden Eigenschaften der Reflexionsstruktur und die damit verbundenen Vorteile für alle Seiten des elektronischen Bauelements und/oder des Funktionskörpers entlang eines Umfangs des elektronischen Bauelements und/oder des Funktionskörpers ausgenutzt werden. Weiterhin bietet diese Ausgestaltung im Gegensatz zu einer lediglich teilweisen Umhüllung des Funktionskörpers mit der Reflexionsstruktur den Vorteil, dass unter Umständen bei der Bestückung einer Komponente mit dem elektronischen Bauelement auf eine lagerichtige Anordnung oder Bestückung verzichtet werden kann. Insbesondere kann so der Aufwand für die Bestückung optimiert werden.

Ein weiterer Aspekt der vorliegenden Anmeldung betrifft ein System mit einem strahlungsemittierenden Bauteil und dem elektronischen Bauelement, wobei das System derart eingerichtet ist, dass die Reflexionsstruktur von dem strahlungsemittierenden Bauteil emittierte Strahlung des vorgegebenen Spektralbereichs reflektiert. Vorzugsweise ist das strahlungsemittierende Bauteil eine Leuchtdiode ("LED" englisch für "light emitting diode") oder ein Leuchtdioden aufweisendes Bauteil. Vorzugsweise emittieren die genannten Leuchtdioden sichtbares Licht.

In einer bevorzugten Ausgestaltung des Systems ist in dem Matrixmaterial ein Pigment angeordnet, wobei das Pigment ausgebildet ist, die Farbe des elektronischen Bauelements an diejenige einer Umgebung des elektronischen Bauelements in dem System anzupassen.

Die Schutzschicht umfasst ein Pigment, wobei das Pigment ausgebildet ist, die Farbe des elektronischen Bauelements an diejenige einer Umgebung des elektronischen Bauelements in dem System anzupassen.

Das Pigment ist zweckmäßigerweise ausgebildet, das elektronische Bauelement und/oder die Schutzschicht in einer beliebigen Farbe des sichtbaren elektromagnetischen Spektrums, zu färben oder für einen Betrachter des elektronischen Bauelements einen entsprechenden Farbreiz hervorzurufen.

Durch die letzten beiden Ausgestaltungen kann die Farbe und/oder die äußere Erscheinung des elektronischen Bauelements beispielsweise an diejenige des Systems oder einer oder mehrerer Komponenten, welche im Betrieb des elektronischen Bauelements mit demselben zusammenwirken oder daneben angeordnet sind, angepasst werden. Auf diese Weise kann ein beispielsweise bezüglich der Farbe einheitlicher Gesamteindruck entstehen. Das Pigment kann beispielsweise ein Metall enthalten oder daraus bestehen. Alternativ oder zusätzlich können die oben beschriebenen strahlungsreflektierenden Partikel als Pigment wirken.

In einer bevorzugten Ausgestaltung des Systems ist die Reflexionsstruktur so gewählt, dass die elektrischen, optischen und/oder mechanischen Eigenschaften der Reflexionsstruktur über die Lebensdauer des strahlungsemittierenden Bauteils hinweg stabil sind. Insbesondere sind dabei vorzugsweise die genannten Eigenschaften über eine Dauer von 20000 Betriebsstunden des strahlungsemittierenden Bauteils stabil. Der Ausdruck "stabil" soll vorliegend bedeuten, dass mindestens eine der genannten Eigenschaften beispielsweise über die genannte Dauer nicht maßgeblich oder signifikant degradiert oder zerstört wird, beispielsweise durch thermische Einflüsse während des Betriebs des strahlungsemittierenden Bauteils oder des Systems.

Ein weiterer Aspekt der vorliegenden Anmeldung betrifft die Verwendung des elektronischen Bauelements für das System.

Weitere Vorteile, vorteilhafte Ausgestaltungen und Zweckmäßigkeiten der Erfindung ergeben sich aus der folgenden Beschreibung der Ausführungsbeispiele in Verbindung mit den Figuren.
- Figur 1A: zeigt eine schematische Schnittansicht eines elektronischen Bauelements.
- Figur 1B: zeigt einen vergrößerten Randbereich des elektronischen Bauelements aus Figur 1A.
- Figur 1C: zeigt einen weiteren Randbereich des elektronischen Bauelements aus Figur 1A in vergrößerter Form.
- Figur 1D: zeigt eine schematische, perspektivische Ansicht des elektronischen Bauelements.
- Figur 2A: zeigt schematisch zumindest eine Teilansicht eines elektronischen Bauelements.
- Figur 2B: zeigt einen vergrößerten Randbereich des elektronischen Bauelements aus Figur 2A.
- Figur 2C: zeigt schematisch zumindest eine Teilansicht eines elektronischen Bauelements.
- Figur 3: zeigt eine schematische Schnitt- oder Seitenansicht eines elektronischen Bauelements gemäß der vorliegenden Erfindung.
- Figur 4: zeigt schematisch ein System mit einem elektronischen Bauelement.

Gleiche, gleichartige und gleich wirkende Elemente sind in den Figuren mit gleichen Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder zum besseren Verständnis übertrieben groß dargestellt sein.

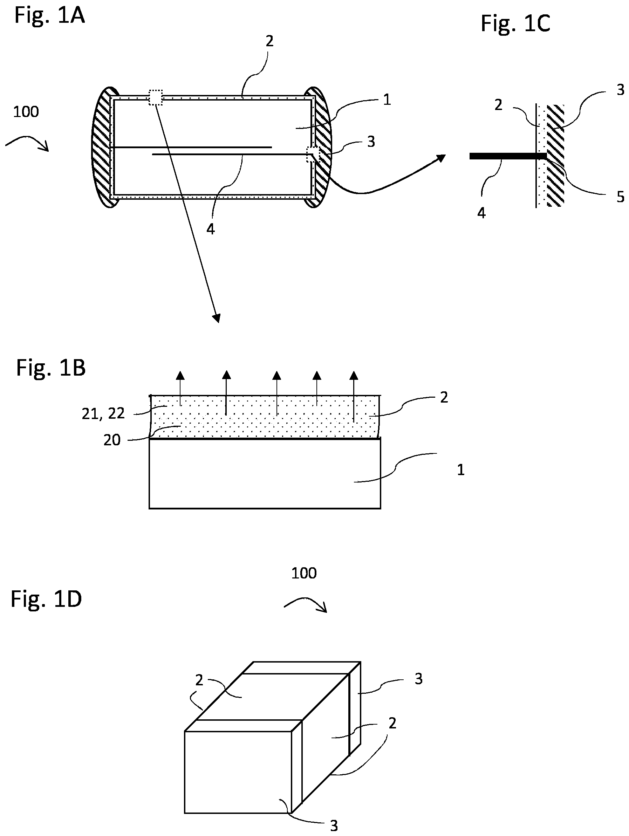

Figur 1A zeigt schematisch eine Schnittansicht eines elektronischen Bauelements 100. Das elektronische Bauelement 100 ist vorzugsweise strahlungspassiv, d. h. kein aktiv strahlungsemittierendes Bauelement, wie beispielsweise eine Leuchtdiode. Das elektronische Bauelement 100 weist einen Funktionskörper 1 auf. Der Funktionskörper 1 ist vorzugsweise die funktionale Komponente entweder eines Varistors, eines Kondensators, eines PTC-Bauelements, eines NTC-Bauelements, eines Ferrite enthaltenden Bauelements, eines piezoelektrischen Bauelements oder eines Halbleiterbauelements. Der Funktionskörper 1 kann demgemäß eine Keramik umfassen oder daraus bestehen. Alternativ kann der Funktionskörper 1 ein vorzugsweise nicht-keramisches Halbleitermaterial umfassen oder daraus bestehen. Das genannte Halbleitermaterial kann Silizium (Si), Germanium (Ge), oder Galliumarsenid (GaAs) sein oder enthalten. Das elektronische Bauelement 100 kann, sofern der Funktionskörper nicht auf einer Keramik basiert sondern auf einem Halbleiter, beispielsweise eine Diode, insbesondere eine Überspannungsschutzdiode und/oder TVS-Diode ("TVS" englisch für "transient-voltage-suppressor"-Diode) sein.

Der Funktionskörper 1 ist mit einer Reflexionsstruktur 2 versehen. Die Reflexionsstruktur 2 ist derart angeordnet und ausgebildet, dass von außen auf das elektronische Bauelement 100 treffende elektromagnetische Strahlung von dem Funktionskörper 1 weg reflektiert wird. Die Reflexionsstruktur 2, insbesondere das Material einer äußeren Oberfläche der Reflexionsstruktur 2 ist vorzugsweise elektrisch isolierend ausgebildet, um möglicherweise einen elektrischen Kontakt zwischen Außenelektroden (siehe unten) zu verhindern. Die Reflexionsstruktur 2 kann durch Schichtabscheideverfahren, beispielsweise durch Aufstäuben, Aufsprühen oder Siebdruck herstellbar oder hergestellt sein. Vorzugsweise ist die Reflexionsstruktur 2 eine Schicht, beispielsweise eine Vielfachfach- oder Mehrfachschicht.

Das elektronische Bauelement 100 weist weiterhin Elektroden oder Innenelektroden 4 auf. In Figur 1A sind zwei teilweise überlappende, sich von gegenüberliegenden Seiten (vgl. Stirnseiten weiter unten) des elektronischen Bauelements 100 erstreckende Innenelektroden beispielhaft eingezeichnet. Alternativ können auch mehrere Innenelektroden vorgesehen sein. Die Innenelektroden 4 sind zweckmäßigerweise elektrisch voneinander isoliert. Die Innenelektroden 4 sind vorzugsweise Innenelektrodenschichten oder schichtweise ausgebildet. Die Innelektroden 4 sind weiterhin größtenteils innerhalb des Funktionskörpers 1 angeordnet.

Das elektronische Bauelement 100 weist zudem zwei Elektroden oder Außenelektroden 3 auf, es können jedoch auch noch weitere Außenelektroden vorgesehen sein. Die Außenelektroden 3 sind außerhalb des Funktionskörpers 2 angeordnet. Des Weiteren sind die Außenelektroden 3 voneinander elektrisch isoliert. Je eine Außenelektrode ist auf einer Stirnseite (vgl. linke und rechte Seite in Figur 1A) des Funktionskörpers 1 oder des elektronischen Bauelements 100 angeordnet oder aufgebracht.

Jede der genannten Innenelektroden 4 ist jeweils an einer Stirnseite mit einer an diesen Stirnseiten angeordneten Außenelektrode 3 elektrisch leitfähig verbunden.

In Figur 1A ist weiterhin gezeigt, dass die Außenelektroden 3 die Reflexionsstruktur 2 teilweise bedecken.

In Figur 1B ist ein Randabschnitt des elektronischen Bauelements 100 vergrößert dargestellt (vgl. nach unten zeigender Pfeil). Es ist zu erkennen, dass die Reflexionsstruktur 2 strahlungsreflektierende Partikel 21 umfasst. Weiterhin umfasst die Reflexionsstruktur 2 ein Matrixmaterial 20 für die strahlungsreflektierende Partikel 21. Die strahlungsreflektierenden Partikel 21 sind zweckmäßigerweise in dem Matrixmaterial angeordnet. Durch die strahlungsreflektierenden Partikel 21 wird von außen auf das elektronische Bauelement 100 oder auf die Reflexionsstruktur 2 treffende elektromagnetische Strahlung vorzugsweise reflektiert oder zurückgestrahlt, was durch die in der Figur 1B dargestellten nach oben zeigenden Pfeile angedeutet ist. Dabei kann die Strahlung zumindest teilweise in die Reflexionsstruktur 2 oder das Matrixmaterial 20 eindringen, bis sie von einem oder mehreren der strahlungsreflektierenden Partikel 21 vorzugsweise von dem Funktionskörper 1 wegreflektiert wird.

Gemäß der in Figur 1B gezeigten Anordnung ist die Reflexionsstruktur 2 vorzugsweise durch ein Aufsprühverfahren abgeschieden worden. Dafür kann zunächst eine Schlickermasse mit dem Matrixmaterial oder einem Grundmaterial dafür und den strahlungsreflektierenden Partikeln 21 als Pigment, also farbgebender- oder definierender Substanz - vorbereitet oder gemischt werden, um dann zusammen zum Ausbilden oder Abscheiden der Reflexionsstruktur auf den Funktionskörper aufgebracht zu werden.

Der Füllfaktor oder Füllanteil der strahlungsreflektierenden Partikel 21 in dem Matrixmaterial 20 kann zwischen 5 % und 50 % betragen. Bevorzugt beträgt der genannte Füllfaktor zwischen 5 % und 30 %. Diese Angaben können sich auf Volumenals auch Massen- oder Gewichtsprozente beziehen.

Die strahlungsreflektierenden Partikel 21 können aus zumindest einem der Materialien Titanoxid, beispielsweise TiO₂, Aluminiumoxid, beispielsweise Al₂O₃, Magnesiumoxid, beispielsweise MgO, Magnesiumsilikat, beispielsweise MgO₃Si, Bariumsulfat, beispielsweise BaSO₄, Zinkoxid, beispielsweise ZnO und Zirkoniumoxid, beispielsweise ZrO₂, bestehen oder zumindest eines der genannten Materialien enthalten. Das Matrixmaterial 20 umfasst vorzugsweise ein Harz, beispielsweise ein Epoxid, oder ein Glas oder besteht aus einem dieser Materialien.

Vorzugsweise ist in dem Matrixmaterial 20 ein Pigment 22 angeordnet. Das Pigment 22 ist vorzugsweise ausgebildet, die Farbe des elektronischen Bauelements an diejenige einer Umgebung des elektronischen Bauelements, beispielsweise in einem System (siehe unten), anzupassen. Das Pigment 22 ist zweckmäßigerweise weiterhin ausgebildet, das elektronische Bauelement in einer beliebigen Farbe des sichtbaren elektromagnetischen Spektrums zu färben oder für einen Betrachter des elektronischen Bauelements einen entsprechenden Farbreiz hervorzurufen. Das Pigment 22 kann, wie oben beschrieben, im Falle, dass das Pigment 22 in dem Matrixmaterial 20 angeordnet ist, auch durch die strahlungsreflektierenden Partikel 21 zur Verfügung gestellt werden. Beispielsweise wird ein Ausgangsmaterial für das Matrixmaterial 20 während der Herstellung des elektronischen Bauelements 100 mit dem Pigment 22 versehen oder versetzt, wobei das Pigment in einen Ausgangsstoff des Matrixmaterials hineinextrudiert werden kann. Beispielsweise kann das Pigment Kobalt (Co) enthalten, um unter Umständen, im Einklang mit einem System, dem strahlungsemittierenden Bauteil (siehe unten) oder einer anderen Komponente, für den Betrachter oder Benutzer des elektronischen Bauelements 100 eine bläuliche Farbe als Farbreiz hervorzurufen. Alternativ kann ein anderes Pigment gewählt werden, um einen anderen Farbeindruck zu erzielen.

Figur 1C zeigt einen Randbereich, insbesondere einen Elektrodenbereich des elektronischen Bauelements 100 in einer vergrößerten Darstellung (vgl. nach rechts zeigender Pfeil). Die Darstellung in Figur 1C ist beispielhaft für eine der Stirnseiten des Funktionskörpers 1 oder des elektronischen Bauelements 100. Es ist in Figur 1C zu erkennen, dass die Reflexionsstruktur 2 in Elektrodenbereichen 5, in denen die Außenelektroden 3 mit den Innenelektroden 4 elektrisch leitfähig verbunden sind, unterbrochen ist. Abgesehen von den Elektrodenbereichen 5 kann die Reflexionsstruktur 2 den Funktionskörper 1 beispielsweise vollständig bedecken. Für die Unterbrechung der Reflexionsstruktur 2 kann diese im Herstellungsverfahren des elektronischen Bauelements durch ein Ätzverfahren beispielsweise eingeätzt und in den Elektrodenbereichen 5 in einem anschließenden Verfahrensschritt weiteres Elektrodenmaterial angeordnet werden.

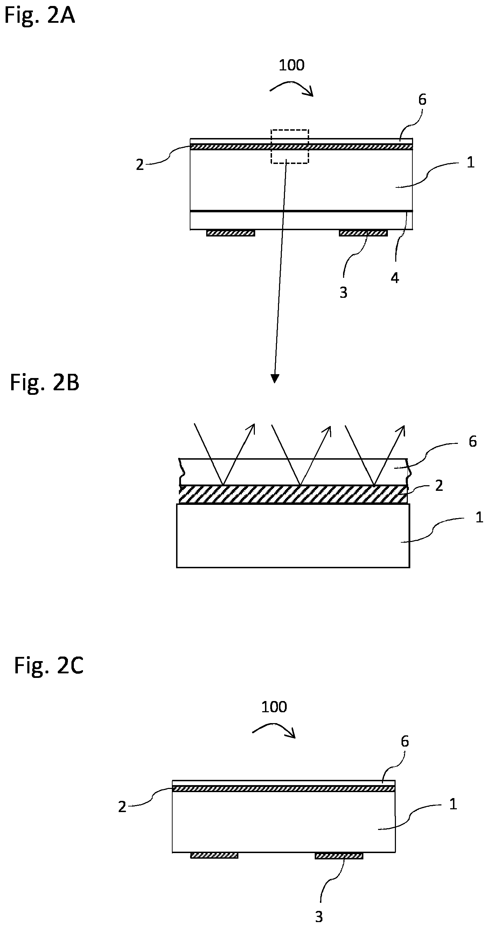

Figur 1D zeigt eine schematische, perspektivische Ansicht des elektronischen Bauelements 100, wie es beispielsweise in den Figuren 1A bis 1C gezeigt ist. Der Funktionskörper 1 kann, wie dargestellt, eckig, beispielsweise quaderförmig, ausgestaltet sein. Alternativ kann der Funktionskörper eine andere Form haben. Es ist weiterhin zu erkennen, dass die Reflexionsstruktur 2 den Funktionskörper 1 (in Figur 1D nicht explizit gekennzeichnet) außer an den Stirnseiten desselben, an denen die Außenelektroden 3 angeordnet sind, beispielsweise über alle vier Seitenflächen vollständig umhüllt oder umschließt, so dass insbesondere die reflektierenden Eigenschaften der Reflexionsstruktur 2 und die damit verbundenen Vorteile für alle Seiten entlang des Umfangs des elektronischen Bauelements 100 ausgenutzt werden können. Alternativ kann die Reflexionsstruktur 2 den Funktionskörper 1 entlang eines Umfangs des Funktionskörpers 1, vorzugsweise entlang eines Umfangs, welcher sich nicht über die Außenelektroden 3 und/oder Stirnseiten 1 erstreckt, nur teilweise, beispielsweise ausschließlich an einzelnen Seitenflächen des Funktionskörpers 1, umschließt (vgl. Ober- und Unterseite des Funktionskörpers 2 in Figur 1A). Figur 2A zeigt das elektronische Bauelement 100 in einer alternativen Ausgestaltung. Im Gegensatz zu den bisher beschriebenen Figuren weist das elektronische Bauelement 100 eine Schutzschicht 6 auf, welche an einer Außenseite auf der Reflexionsstruktur 2 angeordnet ist. Dementsprechend definiert die Schutzschicht 6 vorzugsweise eine äußere Oberfläche des elektronischen Bauelements 100. Beispielsweise kann die Schutzschicht 6 den Funktionskörper 1 vor reaktiven und/oder korrosiven Medien, denen dieser zum Beispiel während der Herstellung des elektronischen Bauelements 100 ausgesetzt ist, schützen.

Die Schutzschicht umfasst ein Pigment.

Analog (vgl. obige Beschreibung) zu dem Matrixmaterial kann die Schutzschicht 6 mit dem Pigment 22 versehen oder versetzt werden.

Weiterhin kann die Schutzschicht 6 durch chemische Gasphasenabscheidung (CVD englisch für "chemical-vapordeposition"), beispielsweise plasmaunterstützte chemische Gasphasenabscheidung (PECVD englisch für "plasma-enhanced" CVD) hergestellt. Die Schutzschicht 6 kann weiterhin eine Schichtdicke zwischen 10 nm und 1 µm aufweisen. Besonders bevorzugt beträgt die Schichtdicke in diesem Fall zwischen 10 nm und 50 nm.

Im Gegensatz zu den Figuren 1A, 1B und 1C sind weiterhin keine innerhalb des Funktionskörpers 1 angeordneten Elektroden gezeigt. Stattdessen ist eine Innenelektrode oder Elektrode 4 gezeigt, welche sich an einer der Reflexionsstruktur 2 gegenüberliegenden Seite des Funktionskörpers 1 über die gesamte Breite der Reflexionsstruktur 2 erstreckt. Die Elektrode 4 ist elektrisch leitfähig mit - beispielhaft dargestellten - zwei weiteren Außenelektroden oder Elektroden 3 verbunden. Die Elektroden 3 sind auf einer dem Funktionskörper abgewandten Seite der Elektroden 4 mit diesen elektrisch leitfähig verbunden. Gemäß dieser Ausgestaltung kann das elektronische Bauelement 100 beispielsweise oberflächenmontierbar und/oder in Wende- oder "flip-chip"-Montage ("flip-chip"-Montage englisch für Wende-Montage) ausgebildet oder ausgestaltet werden, indem beispielsweise das elektronische Bauelement 100 über die Elektroden 3 direkt auf eine Leiterplatte oder eine andere Komponente gelötet oder damit anderweitig elektrisch leitfähig verbunden wird. Alternativ oder zusätzlich kann das elektronische Bauelement 100, beispielsweise über die Elektroden 3 und 4 als LGA-System ausgebildet werden. "LGA" ist eine Abkürzung für "land-grid-array" ("land" englisch für "Kontaktfläche"; "grid" englisch für "Gitter", "Raster" oder "Netz" und "array" englisch für "Feld"). Beim LGA-System werden die Anschlüsse eines elektronischen Bauteils oder Schaltkreises auf seiner Unterseite in Form eines schachbrettartigen Feldes ("grid array") von Kontaktflächen ("lands") ausgeführt. Es ist eng verwandt mit dem BGA-System ("ball grid array"), welches Lotperlen oder Lotkugeln ("ball") für eine elektrische Kontaktierung nutzt.

In Figur 2B ist ein Randbereich des elektronischen Bauelements 100, welcher mit der Reflexionsstruktur 2 versehen ist, vergrößert dargestellt. Es ist zu erkennen, dass auf der Reflexionsstruktur 2, also auf einer Außenseite des elektronischen Bauelements 100, eine Schutzschicht 6 aufgebracht oder angeordnet ist. Die Schutzschicht 6 ist vorzugsweise strahlungstransparent. Weiterhin umfasst die Schutzschicht 6 vorzugsweise ein Epoxid oder ein Glas oder besteht aus einem dieser Materialien. Die Schutzschicht 6 kann, ohne dass dies in den Figuren explizit dargestellt ist, das oben beschriebene Pigment 22 aufweisen. Gemäß dieser Ausgestaltung kann die Reflexionsstruktur 2 weiterhin beispielsweise als zusammenhängende Schicht vollständig aus einem der im Zusammenhang mit den strahlungsreflektierenden Partikeln 21 genannten Materialien bestehen oder eines dieser Materialien umfassen. Die dargestellten Pfeile deuten - ähnlich wie in Figur 1B - die Reflektion von von außen auf das elektronische Bauelement 100 treffende Strahlung an, welche von der Reflexionsstruktur 2 reflektiert wird.

Figur 2C zeigt im Gegensatz zu Figur 2A eine Ausgestaltung des elektronischen Bauelements oder eines Teils davon, wobei der Funktionskörper vorzugsweise ein Halbleitermaterial umfasst, insbesondere ein nicht-keramisches Halbleitermaterial. Im Gegensatz zur Figur 2A sind hier keine Innenelektroden 4 im Funktionskörper 1 vorgesehen, da dies im Falle eines nicht-keramischen Funktionskörpers nicht zweckmäßig ist.

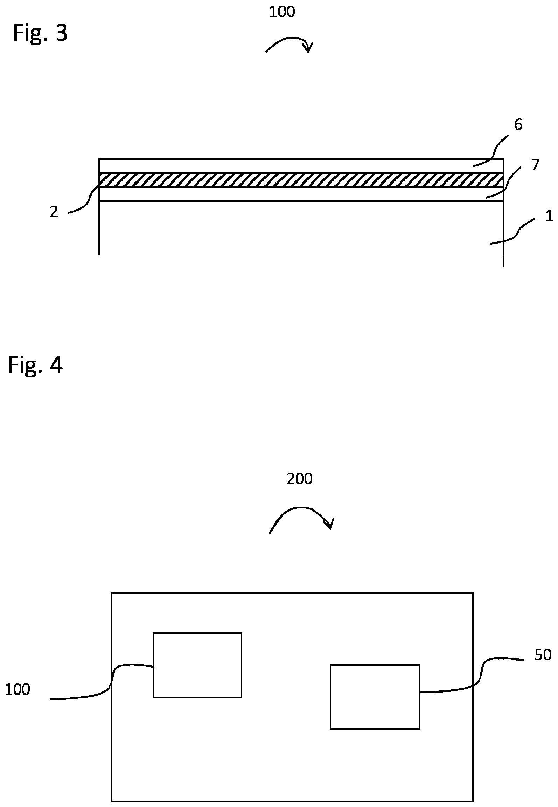

Figur 3 zeigt eine schematische Seiten- oder Schnittansicht des elektronischen Bauelements 100 gemäß der vorliegenden Erfindung. Im Gegensatz zu den bisher beschriebenen Ausgestaltungen weist das elektronische Bauelement 100 eine zwischen dem Funktionskörper 1 und der Reflexionsstruktur angeordnete Barriereschicht 7 auf. Die Barriereschicht ist vorzugsweise aus Bleisilikat oder Borsilikat, kann jedoch zusätzlich oder alternativ auch aus einem anderen Material bestehen. Wie in den Figuren 2A und 2B ist hier auf der Reflexionsstruktur die Schutzschicht 6 angeordnet.

Gemäß der in Figur 2B beziehungsweise Figur 3 gezeigten Ausführungsform ist die Reflexionsstruktur 2 und/oder die Barriereschicht 7 vorzugsweise durch ein Siebdruckverfahren herstellbar oder hergestellt.

Die Reflexionsstruktur 2 kann insgesamt eine Schichtdicke von weniger als 50 µm aufweisen. Bevorzugt weist die Reflexionsstruktur eine Schichtdicke zwischen 1 µm und 10 µm auf. Besonders bevorzugt weist die Reflexionsstruktur 2 eine Schichtdicke zwischen 2 µm und 3 µm auf.

Vorzugsweise weist die Reflexionsstruktur 2 vorliegend für von außen auf das elektronische Bauelement 100 treffende elektromagnetische Strahlung eines vorgegebenen Spektralbereichs einen größeren Reflexionsfaktor und/oder Reflexionsgrad auf, als der Funktionskörper 1. Der vorgegebene Spektralbereich kann den infraroten, den sichtbaren und den ultravioletten Spektralbereich umfassen oder, vorzugsweise, den sichtbaren Spektralbereich definieren.

Vorliegend ist die Reflexionsstruktur 2 bevorzugt derart ausgebildet, dass sie für von außen auf das elektronische Bauelement treffende Strahlung des vorgegebenen Spektralbereichs einen Reflexionsfaktor und/oder Reflexionsgrad von R > 0,9 aufweist. Alternativ kann die Reflexionsstruktur 2 derart ausgebildet sein, dass sie für von außen auf das elektronische Bauelement treffende Strahlung des vorgegebenen Spektralbereichs einen Reflexionsfaktor und/oder Reflexionsgrad von R > 0,7 oder beispielsweise R > 0,8 aufweist.

Gemäß einer weiteren nicht explizit in den Figuren gezeigten Ausgestaltung umfasst die Reflexionsstruktur des elektronischen Bauelements eine Schichtenfolge, beispielsweise umfassend eine Mehrzahl von aufeinander angeordneten Einzelschichten. Gemäß dieser Ausgestaltung kann eine Reflexion von von außen auf das elektronische Bauelement treffender elektromagnetischer Strahlung durch optische Interferenz und/oder Bragg-Reflexion, beispielsweise spektral oder wellenlängenselektiv, an der Reflexionsstruktur erfolgen. Zweckmäßigerweise ist die Reflexionsstruktur dafür entsprechend ausgebildet. Insbesondere können die einzelnen Schichten der Reflexionsstruktur strahlungstransparent ausgestaltet sein. Benachbarte Schichten können ebenfalls einen hohen Brechungsindexunterschied, wie beispielsweise bei einem Bragg-Spiegel, aufweisen. In diesem Sinne kann die genannte Schichtenfolge beispielsweise aus zwei verschiedenen Materialien, die abwechselnd übereinander angeordnet oder aufgebracht sind, bestehen. Gemäß dieser Ausgestaltung können die genannten Schichten der Schichtenfolge ebenfalls zumindest teilweise aus den oben in Verbindung mit den strahlungsemittierenden Partikeln genannten Materialien, vorzugsweise ohne TiO₂ bestehen und durch Aufstäuben oder Kathodenzerstäubung ("sputtern") abgeschieden werden.

Figur 4 zeigt eine schematische Ansicht eines Systems 200. Das System 200 weist ein strahlungsemittierendes Bauteil 50 auf. Weiterhin weist das System 200 das elektronische Bauelement 100 gemäß zumindest einer der anhand der weiter oben beschriebenen Figuren gezeigten Ausführungsformen auf.

Das System 200 ist vorzugsweise derart eingerichtet, dass die Reflexionsstruktur 2 von dem strahlungsemittierenden Bauteil 50 emittierte elektromagnetische Strahlung des vorgegebenen Spektralbereichs reflektiert. Dazu ist das elektronische Bauelement vorzugsweise derart relativ zu dem strahlungsemittierenden Bauteil 50 angeordnet, dass eine optische Wechselwirkung zwischen den genannten Komponenten möglich ist. Insbesondere kann das elektronische Bauelement 100 in einem Abstrahlungsbereich oder Strahlengang des strahlungsemittierenden Bauteils 50 angeordnet sein. Weiterhin ist die Reflexionsstruktur 2 (siehe oben) vorzugsweise so gewählt, dass die elektrischen, optischen und/oder mechanischen Eigenschaften der Reflexionsstruktur über die Lebensdauer des strahlungsemittierenden Bauteils 50 hinweg stabil sind. Insbesondere sind dabei vorzugsweise die genannten Eigenschaften über eine Dauer von 20000 Betriebsstunden des strahlungsemittierenden Bauteils 100 oder des Systems 200 stabil.

### Bezugszeichenliste

- 1: Funktionskörper
- 2: Reflexionsstruktur
- 3: Außenelektrode
- 4: Innenelektrode
- 5: Elektrodenbereich
- 6: Schutzschicht
- 7: Barriereschicht
- 20: Matrixmaterial
- 21: Strahlungsreflektierende Partikel
- 22: Pigment
- 50: Strahlungsemittierendes Bauteil

- 100: Elektronisches Bauelement
- 200: System

## Patentansprüche

1. Elektronisches Bauelement (100) mit einem Funktionskörper (1), der mit einer Reflexionsstruktur (2) versehen ist, wobei die Reflexionsstruktur (2) angeordnet und ausgebildet ist, von außen auf das elektronische Bauelement (100) treffende Strahlung von dem Funktionskörper (1) weg zu reflektieren, wobei das elektronische Bauelement (100) strahlungspassiv ist, wobei das elektronische Bauelement (100) eine Schutzschicht (6) umfasst, die auf der Reflexionsstruktur (2) angeordnet ist, wobei die Schutzschicht (6) ein Pigment (22) umfasst, und wobei das Pigment ausgebildet ist, die Farbe des elektronischen Bauelements (100) an diejenige einer Umgebung des elektronischen Bauelements (100) anzupassen, und wobei das elektronische Bauelement (100) eine Barriereschicht (7) umfasst, die zwischen dem Funktionskörper und der Reflexionsstruktur (2) angeordnet ist.

2. Elektronisches Bauelement (100) nach Anspruch 1, wobei das Material einer äußeren Oberfläche der Reflexionsstruktur (2) elektrisch isolierend ist.

3. Elektronisches Bauelement (100) nach Anspruch 1 oder 2, wobei der Funktionskörper (1) eine Keramik als funktionales Element umfasst.

4. Elektronisches Bauelement (100) nach Anspruch 1 oder 2, wobei der Funktionskörper (1) ein nicht-keramisches Halbleitermaterial als funktionales Element umfasst.

5. Elektronisches Bauelement (100) nach mindestens einem der vorhergehenden Ansprüche, wobei die Reflexionsstruktur (2) eine Schichtdicke zwischen 1 µm und 10 µm aufweist.

6. Elektronisches Bauelement (100) nach mindestens einem der vorhergehenden Ansprüche, wobei die Reflexionsstruktur (2) für von außen auf das elektronische Bauelement (100) treffende Strahlung eines vorgegebenen Spektralbereichs einen größeren Reflexionsfaktor oder Reflexionsgrad aufweist als der Funktionskörper (1), und wobei der vorgegebene Spektralbereich den sichtbaren Spektralbereich umfasst oder aus dem sichtbaren Spektralbereich besteht.

7. Elektronisches Bauelement (100) nach mindestens einem der vorhergehenden Ansprüche, wobei die Reflexionsstruktur (2) derart ausgebildet ist, dass sie für von außen auf das elektronische Bauelement (100) treffende Strahlung einen Reflexionsfaktor oder Reflexionsgrad von R > 0,9 aufweist.

8. Elektronisches Bauelement (100) nach mindestens einem der vorhergehenden Ansprüche, welches elektrisch voneinander isolierte Innenelektroden (4) aufweist, die innerhalb des Funktionskörpers (1) angeordnet sind, und Außenelektroden (3), die außerhalb des Funktionskörpers (1) angeordnet sind, wobei zwei Außenelektroden (3) elektrisch voneinander isoliert und mit verschiedenen elektrisch voneinander isolierten Innenelektroden (4) elektrisch leitfähig verbunden sind.

9. Elektronisches Bauelement (100) nach Anspruch 8, wobei die Reflexionsstruktur (2) zumindest teilweise zwischen den Außenelektroden (3) und dem Funktionskörper (1) angeordnet und in Elektrodenbereichen (5), in denen die Außenelektroden (3) mit den Innenelektroden (4) elektrisch leitfähig verbunden sind, unterbrochen ist.

10. Elektronisches Bauelement (100) nach mindestens einem der vorhergehenden Ansprüche, wobei die Reflexionsstruktur (2) strahlungsreflektierende Partikel (21) umfasst, welche in einem Matrixmaterial (20) der Reflexionsstruktur (2) angeordnet sind.

11. Elektronisches Bauelement (100) nach mindestens einem der vorhergehenden Ansprüche, wobei die Schutzschicht (6) aus einem Glas oder einem Harz, beispielsweise einem Epoxid, besteht oder eines dieser Materialien umfasst.

12. Elektronisches Bauelement (100) nach mindestens einem der vorhergehenden Ansprüche, wobei die Schutzschicht (6) eine Schichtdicke zwischen 10 nm und 1 µm aufweist.

13. Elektronisches Bauelement (100) nach mindestens einem der vorhergehenden Ansprüche, wobei die Reflexionsstruktur (2) den Funktionskörper (1) entlang eines Umfangs des Funktionskörpers (1) nur teilweise umschließt.

14. Elektronisches Bauelement (100) nach mindestens einem der Ansprüche 1 bis 12, wobei die Reflexionsstruktur (2) den Funktionskörper (1) entlang eines Umfangs des Funktionskörpers (1) vollständig umschließt.

15. Elektronisches Bauelement (100) nach mindestens einem der vorhergehenden Ansprüche, welches ein Varistor, ein Kondensator, ein PTC-Bauelement, ein NTC-Bauelement, ein piezoelektrisches Bauelement, ein Ferrite enthaltendes Bauelement oder ein Halbleiterbauelement ist.

16. Elektronisches Bauelement (100) nach mindestens einem der vorhergehenden Ansprüche, welches oberflächenmontierbar und/oder in "flip-chip"-Montage ausgebildet ist.

17. System (200) mit einem strahlungsemittierenden Bauteil (50) und mit einem elektronischen Bauelement (100) nach mindestens einem der vorhergehenden Ansprüche, wobei das System (200) derart eingerichtet ist, dass die Reflexionsstruktur (2) von dem strahlungsemittierenden Bauteil (50) emittierte Strahlung reflektiert.

18. Verwendung eines elektronischen Bauelements (100) nach mindestens einem der Ansprüche 1 bis 16 für ein System (200) nach Anspruch 17.

## Claims

1. Electronic component (100) comprising a functional body (1) provided with a reflection structure (2), wherein the reflection structure (2) is arranged and designed to reflect radiation that impinges on the electronic component (100) from outside away from the functional body (1), wherein the electronic component (100) is radiation-passive, wherein the electronic component (100) comprises a protective layer (6), which is arranged on the reflection structure (2), wherein the protective layer (6) comprises a pigment (22), and wherein the pigment is designed to adapt the colour of the electronic component (100) to that of surroundings of the electronic component (100), and wherein the electronic component (100) comprises a barrier layer (7), which is arranged between the functional body and the reflection structure (2).

2. Electronic component (100) according to Claim 1, wherein the material of an outer surface of the reflection structure (2) is electrically insulating.

3. Electronic component (100) according to Claim 1 or 2, wherein the functional body (1) comprises a ceramic as functional element.

4. Electronic component (100) according to Claim 1 or 2, wherein the functional body (1) comprises a non-ceramic semiconductor material as functional element.

5. Electronic component (100) according to at least one of the preceding claims, wherein the reflection structure (2) has a layer thickness of between 1 um and 10 µm.

6. Electronic component (100) according to at least one of the preceding claims, wherein the reflection structure (2) has a greater reflection factor or reflectance for radiation in a predefined spectral range that impinges on the electronic component (100) from outside than the functional body (1), and wherein the predefined spectral range comprises the visible spectral range or consists of the visible spectral range.

7. Electronic component (100) according to at least one of the preceding claims, wherein the reflection structure (2) is designed in such a way that it has a reflection factor or reflectance of R > 0.9 for radiation that impinges on the electronic component (100) from outside.

8. Electronic component (100) according to at least one of the preceding claims, which has internal electrodes (4) that are electrically insulated from one another and are arranged within the functional body (1), and external electrodes (3) that are arranged outside the functional body (1), wherein two external electrodes (3) are electrically insulated from one another and electrically conductively connected to different internal electrodes (4) that are electrically insulated from one another.

9. Electronic component (100) according to Claim 8, wherein the reflection structure (2) is at least partly arranged between the external electrodes (3) and the functional body (1) and interrupted in electrode regions (5) in which the external electrodes (3) are electrically conductively connected to the internal electrodes (4).

10. Electronic component (100) according to at least one of the preceding claims, wherein the reflection structure (2) comprises radiation-reflecting particles (21) arranged in a matrix material (20) of the reflection structure (2).

11. Electronic component (100) according to at least one of the preceding claims, wherein the protective layer (6) consists of a glass or a resin, for example an epoxy, or comprises one of these materials.

12. Electronic component (100) according to at least one of the preceding claims, wherein the protective layer (6) has a layer thickness of between 10 nm and 1 µm.

13. Electronic component (100) according to at least one of the preceding claims, wherein the reflection structure (2) only partly encloses the functional body (1) along a circumference of the functional body (1).

14. Electronic component (100) according to at least one of Claims 1 to 12, wherein the reflection structure (2) completely encloses the functional body (1) along a circumference of the functional body (1).

15. Electronic component (100) according to at least one of the preceding claims, which is a varistor, a capacitor, a PTC component, an NTC component, a piezoelectric component, a component containing ferrites, or a semiconductor component.

16. Electronic component (100) according to at least one of the preceding claims, which is designed to be surface-mountable and/or using "flip-chip" mounting.

17. System (200) comprising a radiation-emitting device (50) and comprising an electronic component (100) according to at least one of the preceding claims, wherein the system (200) is designed in such a way that the reflection structure (2) reflects radiation emitted by the radiation-emitting device (50).

18. Use of an electronic component (100) according to at least one of Claims 1 to 16 for a system (200) according to Claim 17.

## Revendications

1. Composant électronique (100) comprenant un corps fonctionnel (1) qui est pourvu d'une structure de réflexion (2), la structure de réflexion (2) étant disposée et conçue de manière à réfléchir depuis le corps fonctionnel (1) le rayonnement incident de l'extérieur au composant électronique (100), le composant électronique (100) étant passif vis-à-vis du rayonnement, le composant électronique (100) comprenant une couche de protection (6) qui est disposée sur la structure de réflexion (2), la couche de protection (6) comprenant un pigment (22), et le pigment étant conçu pour adapter la couleur du composant électronique (100) à celle d'un environnement du composant électronique (100), et, le composant électronique (100) comprenant une couche barrière (7) qui est disposée entre le corps fonctionnel et la structure de réflexion (2).

2. Composant électronique (100) selon la revendication 1, le matériau d'une surface extérieure de la structure de réflexion (2) étant électriquement isolant.

3. Composant électronique (100) selon la revendication 1 ou 2, le corps fonctionnel (1) comprenant une céramique comme élément fonctionnel.

4. Composant électronique (100) selon la revendication 1 ou 2, le corps fonctionnel (1) comprenant un matériau semi-conducteur non céramique comme élément fonctionnel.

5. Composant électronique (100) selon l'une au moins des revendications précédentes, la structure de réflexion (2) ayant une épaisseur de couche comprise entre 1 µm et 10 µm.

6. Composant électronique (100) selon l'une au moins des revendications précédentes, la structure de réflexion (2) ayant un facteur de réflexion ou un degré de réflexion supérieur à celui du corps fonctionnel (1) pour un rayonnement d'un domaine spectral spécifié qui est incident au composant électronique (100) depuis l'extérieur, et le domaine spectral spécifié comprenant le domaine spectral visible ou étant le domaine spectral visible.

7. Composant électronique (100) selon l'une au moins des revendications précédentes, la structure de réflexion (2) étant conçue de manière à avoir un facteur de réflexion ou un degré de réflexion de R > 0,9 pour un rayonnement incident au composant électronique (100) depuis l'extérieur.

8. Composant électronique (100) selon l'une au moins des revendications précédentes, lequel comporte des électrodes intérieures (4) isolées électriquement les unes des autres et disposées à l'intérieur du corps fonctionnel (1) et des électrodes extérieures (3) disposées à l'extérieur du corps fonctionnel (1), deux électrodes extérieures (3) isolées électriquement l'une de l'autre et reliées de manière électriquement conductrice à différentes électrodes intérieures (4) isolées électriquement les unes des autres.

9. Composant électronique (100) selon la revendication 8, la structure de réflexion (2) étant au moins partiellement disposée entre les électrodes extérieures (3) et le corps fonctionnel (1) et étant interrompue dans des zones d'électrodes (5) dans lesquelles les électrodes extérieures (3) sont reliées de manière électriquement conductrice aux électrodes intérieures (4).

10. Composant électronique (100) selon l'une au moins des revendications précédentes, la structure de réflexion (2) comprenant des particules (21) réfléchissant un rayonnement qui sont disposées dans un matériau matriciel (20) de la structure de réflexion (2) .

11. Composant électronique (100) selon l'une au moins des revendications précédentes, la couche de protection (6) étant constituée de verre ou de résine, par exemple un époxy, ou comprenant un de ces matériaux.

12. Composant électronique (100) selon l'une au moins des revendications précédentes, la couche de protection (6) ayant une épaisseur de couche comprise entre 10 nm et 1 µm.

13. Composant électronique (100) selon l'une au moins des revendications précédentes, la structure de réflexion (2) n'enfermant que partiellement le corps fonctionnel (1) le long d'une circonférence du corps fonctionnel (1).

14. Composant électronique (100) selon l'une au moins des revendications 1 à 12, la structure de réflexion (2) enfermant complètement le corps fonctionnel (1) le long d'une circonférence du corps fonctionnel (1).

15. Composant électronique (100) selon l'une au moins des revendications précédentes, lequel est une varistance, un condensateur, un composant PTC, un composant NTC, un composant piézoélectrique, un composant contenant des ferrites ou un composant semi-conducteur.

16. Composant électronique (100) selon l'une au moins des revendications précédentes, lequel peut être monté en surface et/ou est conçu selon un montage « flip-chip ».

17. Système (200) comprenant un composant émetteur de rayonnement (50) et un composant électronique (100) selon l'une au moins des revendications précédentes, le système (200) étant conçu de manière à ce que la structure de réflexion (2) réfléchisse le rayonnement émis par le composant émetteur de rayonnement (50).

18. Utilisation d'un composant électronique (100) selon l'une au moins des revendications 1 à 16 pour un système (200) selon la revendication 17.
